# EUROPEAN PATENT APPLICATION

(11) **EP 3 477 857 A1**
(43) Date of publication of application: **01.05.2019**
(21) Application number: 17199450.2
(22) Date of filing: 31.10.2017
(51) Int. Cl.: H03G 3/02, H03G 3/30, G06F 3/16

(54) **ELECTRONIC DEVICE, METHOD OF OPERATION AND COMPUTER PROGRAM**

(71) Applicant: Vestel Elektronik Sanayi ve Ticaret A.S., 45030 Manisa (TR)
(72) Inventor: DERELÍ,, Ulas, 45030 Manisa (TR)
(74) Representative: Whitfield, Ian

(57) **Abstract**

An electronic device (1) has an audio playback function. The electronic device (1) includes: a controller configured to: provide control of the volume for playback by the electronic device (1) using a first volume scale (30). The first volume scale (30) contains a first sequence of volume levels (31) that each correspond to a different volume for playback (32). The controller is also configured to switch between the first volume scale (30) and a second volume scale (40). The second volume scale (40) contains a second sequence of volume levels (41) that each correspond to a different volume for playback (42). The second volume scale (40) has a smaller interval of volume change between its volume levels (41) compared to the first volume scale (30) such that the second volume scale (40) has a greater number of selectable volume levels (41) than the first volume scale (30).

## Description

### Technical Field

The present disclosure relates to an electronic device, a method of operating an electronic device and a computer program.

### Background

Electronic devices, such as televisions, mobile phones, tablet computers etc., typically have an audio playback function and therefore include or can be connectable to one or more loudspeakers that can output the sound of media content, such as films/movies, television programmes, music, etc. The volume of the audio playback output by the speakers (i.e. the loudness of the sound) can be increased or decreased by a user depending on the user's preference.

### Summary

According to a first aspect disclosed herein, there is provided an electronic device having an audio playback function, the electronic device comprising: a controller configured to: provide a user with control of the volume for playback by the electronic device using a first volume scale, the first volume scale containing a first sequence of volume levels that each correspond to a different volume for playback by the electronic device, the first volume scale extending between a first volume and a second volume; and switch between the first volume scale and a second volume scale, the second volume scale containing a second sequence of volume levels that each correspond to a different volume for playback by the electronic device, the second volume scale extending between the first volume and the second volume, wherein the second volume scale has a smaller interval of volume change between at least two of its volume levels compared to the first volume scale, such that the second volume scale has a greater number of selectable volume levels than the first volume scale.

This allows for the provision of a higher number selectable volume levels in certain situations, which gives a user a greater degree of control of the volume for playback by the electronic device in those situations. This is particularly advantageous in a scenario where the volume of the electronic device is low (e.g. at night), especially because known systems use a logarithmic volume scale to map selectable volume levels to volumes for playback, which can result in a lack of control over the volume for playback at low volume levels in the prior art. That is, a small change in a low volume level can cause a relatively large change in the loudness of the sound output by the electronic device in the prior art. In this situation a user's desired volume for playback may be between two volume levels that are relatively very different and therefore the user cannot select their ideal volume. In arrangements disclosed herein, an alternative second volume scale that adds new volume levels and corresponding volumes for playback is provided between the volume levels and volumes of the first volume scale. In addition, the second volume scale is optional in the sense that the user can switch back to the first volume scale in other situations where finer control of the volume for playback is not required (e.g. at high volumes).

In an example, the controller is configured to switch between the first volume scale and the second volume scale in response to user input.

In an example, the electronic device comprises a receiver for receiving control signals from a remote control device, wherein the controller is configured to switch between the first volume scale and the second volume scale in response to user input from a remote control device.

In an example, the controller is configured to switch between the first volume scale and the second volume scale based on the time of day.

In an example, the controller is configured to switch between the first volume scale and the second volume scale based on a time of day configured by a user.

In an example, the second volume scale includes smaller intervals between the volume levels and volumes for playback in the lower half of the volume scale than in the upper half of the volume scale.

In an example, the electronic device comprises data storage and wherein the first volume scale and the second volume scale are stored as information on the data storage.

According to a second aspect disclosed herein, there is provided a method for operating an electronic device having an audio playback function, the method comprising: switching between a first volume scale and a second volume scale, the first volume scale containing a first sequence of volume levels that each correspond to a different volume for playback by the electronic device, the first volume scale extending between a first volume and a second volume, the second volume scale containing a second sequence of volume levels that each correspond to a different volume for playback by the electronic device, the second volume scale extending between the first volume and the second volume, wherein the second volume scale has a smaller interval of volume change between at least two of its volume levels compared to the first volume scale, such that the second volume scale has a greater number of selectable volume levels than the first volume scale.

In an example, the method comprises switching between the first volume scale and the second volume scale in response to user input.

In an example, the method comprises switching between the first volume scale and the second volume scale in response to user input from a remote control device.

In an example, the method comprises switching between the first volume scale and the second volume scale based on the time of day.

In an example, the method comprises receiving user input to configure a time of day for switching between the first volume scale and the second volume scale.

In an example, the second volume scale includes smaller intervals between the volume levels and volumes for playback in the lower half of the volume scale than in the upper half of the volume scale.

In an example, the method comprises storing the first volume scale and the second volume scale on data storage.

According to a third aspect disclosed herein, there is provided a computer program comprising instructions such that when the computer program is executed on an electronic device having an audio playback function, the electronic device is arranged to: provide a user with control of the volume for playback by the electronic device using a first volume scale, the first volume scale containing a first sequence of volume levels that each correspond to a different volume for playback by the electronic device, the first volume scale extending between a first volume and a second volume; and switch between the first volume scale and a second volume scale, the second volume scale containing a second sequence of volume levels that each correspond to a different volume for playback by the electronic device, the second volume scale extending between the first volume and the second volume, wherein the second volume scale has a smaller interval of volume change between at least two of its volume levels compared to the first volume scale, such that the second volume scale has a greater number of selectable volume levels than the first volume scale.

### Brief Description of the Drawings

To assist understanding of the present disclosure and to show how embodiments may be put into effect, reference is made by way of example to the accompanying drawings in which:
Figure 1 shows schematically an elevation view of an example of an electronic device;
Figure 2 shows an example of a volume scale stored in the data storage of the electronic device shown in Figure 1;
Figure 3 shows an example of another volume scale stored in the data storage of the electronic device shown in Figure 1; and
Figure 4 shows an example of a method of operation of the electronic device shown in Figure 1.

### Detailed Description

Electronic devices, such as televisions, mobile phones, tablet computers, etc., typically have an audio playback function and therefore include or can be connected to one or more loudspeakers that can output the sound of media content, such as films/movies, television programmes, music, etc. The volume of the audio playback output by the speakers (i.e. the loudness of the sound) can be increased or decreased by a user depending on the user's preference.

The volume of the audio playback is selectable by a user providing user input, for example by using a remote control device, by using a user interface or by operating two or more physical (real) buttons or knobs or the like built into the electronic device. When adjusting the volume for playback, the user does not select a specific volume directly (e.g. the user does not set a sound intensity directly, in dB (decibels) or the like). The user instead selects a volume level that corresponds to a particular desired loudness. To this end, the electronic device includes a volume scale, which is a table of volume levels and their corresponding volume for playback.

Due to the manner in which humans perceive sound, a logarithmic scale is used to map the selectable volume levels to the volumes for playback by an electronic device. Consequently, in known systems, a change in loudness when a user switches between two adjacent low volume levels is large compared to when switching between two adjacent high volume levels. This can be problematic in certain situations, such as at night when the user may be attempting to keep the playback volume low.

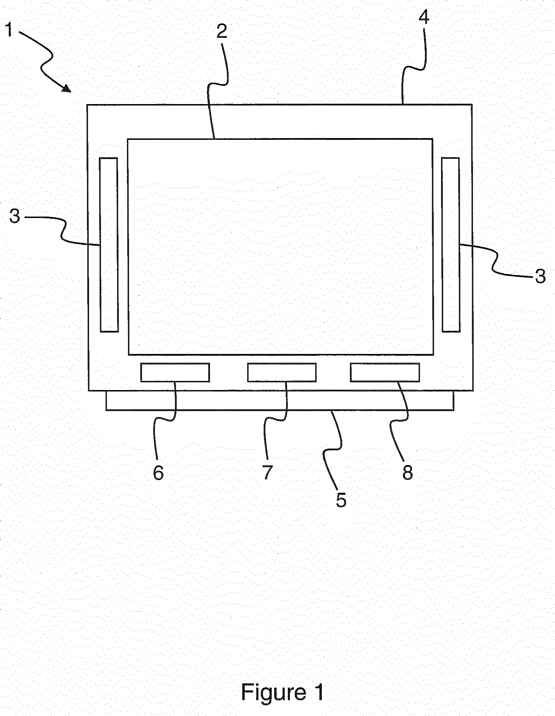

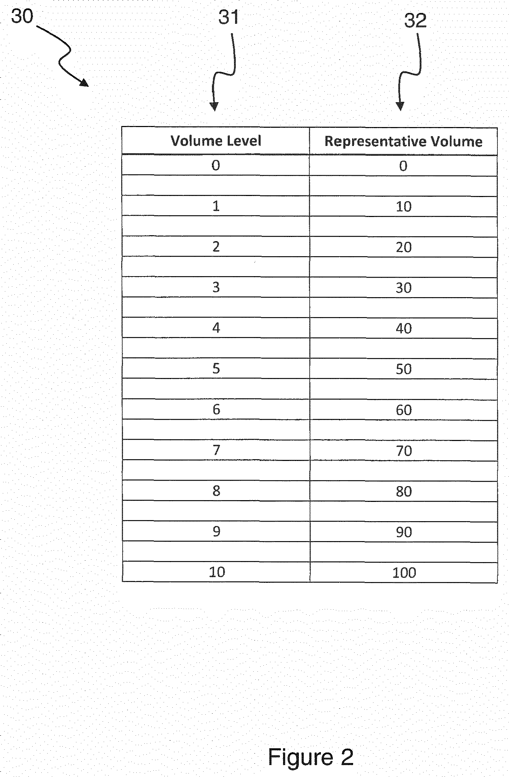

Referring now to Figures 1 and 2, there is shown schematically an example of an electronic device 1 including a display 2 and two loudspeakers 3. The display 2 and the speakers 3 are held within a housing 4. The housing 4 is supported off the ground by a base 5. In this example, the electronic device 1 is a television. In another example, the electronic device 1 is another device that has an audio playback/output function. For example, the electronic device 1 may be a mobile phone (e.g. a smart phone or the like), a computer such as a personal computer, laptop or tablet with media player software, some other computer visual display unit, a radio, CD, MP3 or other hardware media player, etc. The speakers 3 may be integral with the device or may be provided separately.

The speakers 3 output sound corresponding to media content being output by the electronic device 1. The volume (i.e. the loudness) of the sound output by the speakers 3 is adjustable by adjusting the volume level of the electronic device 1. The speakers 3 may be for example dynamic speakers.

The base 5 provides for a connection (not shown) to a source of electricity, such as a mains electricity connection. The electronic device 1 also includes a power button (not shown) for activating and deactivating the electronic device 1.

In this example, the electronic device 1 also includes a data storage 6, a controller 7 and a receiver 8.

The data storage 6 stores information on one or more volume scales. In this example, the data storage 6 stores information on at least a first volume scale and a second volume scale, which are discussed further below. Each volume scale contains a particular sequence of volume levels. Each volume level in a sequence corresponds to a different volume for audio playback by the electronic device 1 through the speakers 3. A user can increase or decrease the volume level set for the electronic device 1, which provides a corresponding increase or decrease of the volume for playback by the electronic device 1. The user can select the volume level by, for example, using a remote control device, using a user interface or by operating two or more physical buttons or knobs built into the electronic device 1. Therefore, a user can control the loudness of the sound output by the speakers 3 so that it is at a preferred volume.

Providing multiple volume scales allows for use of volume scales having different characteristics. In this example, although the overall volume range for the first and second volume scales is the same (i.e. they have the same minimum and maximum volume for playback), for some volume levels, the change in the volume for playback caused by moving between two volume levels of the first volume scale is different from the change in the volume for playback caused by moving between two volume levels of the second volume scale. That is, the interval of loudness change that is controllable by a user is different. In this example, the second volume scale has a greater number of selectable volume levels than the first volume scale, with the difference in volume between adjacent volume levels in the second volume scale being less than the difference in volume between adjacent volume levels in the first volume scale. This is particularly useful at lower volume levels when the volume for playback is relatively quiet because it enables a finer adjustment of volume levels when a user switches between low volume levels. This allows the user to select a volume level corresponding to a volume that is more in line with their preferred volume and avoids large jumps in volume which would arise if the first volume scale was used.

The controller 7, which may be a processor or the like, is provided within the housing 4 for controlling the operation of the electronic device 1. The controller 7 is connected to the speakers 3, the data storage 6 and the receiver 8.

The receiver 8 is constructed and arranged to receive control signals that are output by a corresponding remote control device. The remote control device and the receiver 8 may communicate by using, for example, infrared communication.

The controller 7 is configured to set one of the volume scales stored in the data storage 6 as the volume scale to be used by the electronic device 1. The controller 7 therefore provides a user with control of the volume for playback by the electronic device 1.

The controller 7 is also configured to switch between volume scales stored in the data storage 6. In this example, the controller 7 is configured to switch between the first volume scale and the second volume scale. In an example, the controller 7 is configured to switch between different volume scales in response to user input, i.e. the user is provided with functionality, either by the device 100 itself or by for example a dedicated volume switch button on a remote control device, to switch between different volume scales. The user input may be received in the form of the receiver 8 receiving a control signal from a remote control device. In another example, the controller 7 is configured to switch automatically and autonomously between different volume scales based on the time of day that the electronic device 1 is active. For example, the electronic device 1 may use the first volume scale during the day (e.g. 7am-11pm) and may use the second volume scale during the night (e.g. 11.pm-7am). In an example, the time period in a day that a controller 7 sets a particular volume scale for use by the electronic device 1 is defined by a user. In another example, the time period in a day that each volume scale is used by the electronic device 1 is set by the manufacturer.

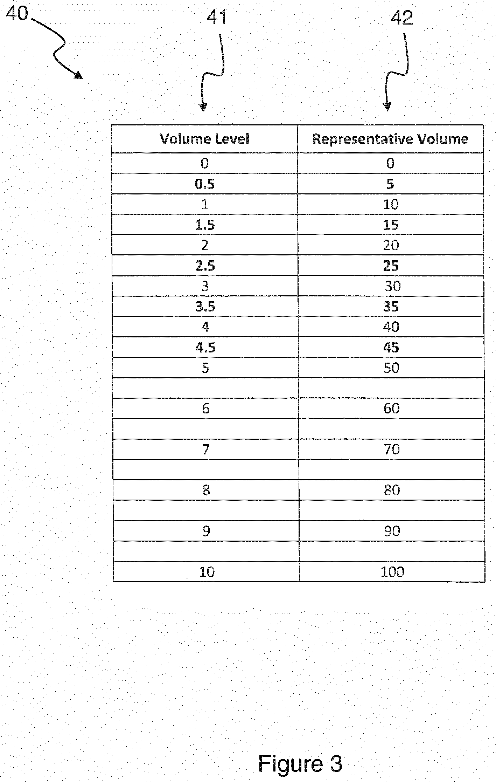

Figure 3 shows an example of a first volume scale 30. In this example, the first volume scale 30 is stored on the data storage 6. The first volume scale 30 contains a first sequence of volume levels 31 that correspond to different volumes for playback 32 by the electronic device 1.

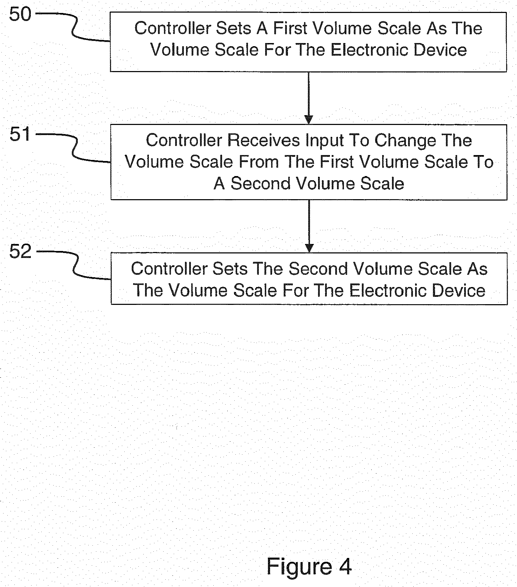

Figure 4 shows an example of a second volume scale 40. In this example, the second volume scale 40 is also stored on the data storage 6. The second volume scale 40 contains a second sequence of volume levels 41 that correspond to different volumes for playback 42 by the electronic device 1.

In this example, the volumes for playback 32, 42 shown schematically in Figures 3 and 4 are not the actual loudness but are representative of the loudness. The first volume scale 30 and the second volume scale 40 both extend between the same minimum first volume and maximum second volume. In this example, the minimum, lowest volume is 0 (i.e. no sound is output by the speakers 3) and the maximum, highest volume is 100.

In this example, the first volume scale 30 contains eleven user-selectable volume levels 31 and the difference in volume for playback 32 between each volume level 31 is "10". In contrast, the second volume scale 40 contains sixteen user-selectable volume levels 32. The difference in volume for playback 42 between each volume level 41 varies across the second volume scale 40. The lower end of the second volume 40 contains a number of intermediate volume levels. As can be seen, there is an intermediate volume level of "x.5" between each of the volume levels "0", "1", "2", "3", "4" and "5". The difference in volume for playback 42 between these volume levels is "5" rather than "10" as in the first volume scale 30. The difference in volume for playback 42 between the higher end of the second volume scale 40 (above a volume level of "5") remains as "10". The volume change between adjacent volume levels 41 of the second volume scale 40 is smaller than between the volume levels 31 of the first volume scale 30 for at least some of the volume levels (i.e. the lower volume levels in this example). Accordingly, the second volume scale 40 provides the user with a greater number of selectable volume levels 41 and thus finer control of the volume for playback 42 than the first volume scale 30.

Other examples may use different numbers of volume levels with different relative spacings of loudness between adjacent volume levels in the second volume scale 40.

An example of a method of the controller 7 switching between different volume scales is shown in Figure 4.

Initially, the electronic device 1 is in a deactivated state.

A user, wanting to activate the electronic device 1, presses a power button located on the electronic device 1. The controller 7 detects that the power button has been pressed and activates the electronic device 1. In another example, the user may activate the electronic device 1 by using a power button located on a remote control device.

On start-up of the electronic device 1, the controller 7 sets the first volume scale 30 as the volume scale for use by the electronic device 1. (The first volume scale 30 may be regarded as a default in that sense.) The controller 7 may also set the volume level of the electronic device to be the same volume level that was chosen by the user before the electronic device 1 was deactivated.

In this example, the controller 7 sets the volume level to be "2", which corresponds to a representative volume of "20". Therefore, when the controller 7 is using the first volume scale 30, if a user decides to increase the volume level by one level, for example by pressing a "Volume Up" button a remote control device once, the controller increases the volume level to "3", which corresponds to a new representative volume of "30".

Similarly, if a user decides to decrease the volume level by one level, for example by pressing a "Volume Down" button a remote control device once, the controller 7 decreases the volume level to "1", which corresponds to a new representative volume of "10".

At certain times of the day (e.g. at night) or in certain situations, a user may prefer smaller increments or intervals between the representative volumes in order to set the volume for playback by the electronic device 1 to be at their desired volume, or to provide the user with more control of the volume for playback. In this example, the user can provide user input to the controller 7 to prompt the controller 7 to switch the volume scale of the electronic device 1 between the first volume scale 30 and the second volume scale 40, which has a greater number of selectable volume levels than the first volume scale 30. In this example, the user provides user input by pressing buttons on a remote control device. Specifically, the user provides user input to switch between the first volume scale 30 and the second volume scale 40 by pressing a dedicated "Switch Volume Scale" button. In another the user may provide user input by operating a user interface or by pressing two or more buttons built into the electronic device 1.

When the controller 7 is using the second volume scale 40, if a user decides to increase the volume level from "2" by one level, for example by pressing a "Volume Up" button a remote control device once, the controller increases the volume level to "2.5", which corresponds to a new representative volume of "25".

Similarly, if a user decides to decrease the volume level from "2" by one level, for example by pressing a "Volume Down" button a remote control device once, the controller 7 decreases the volume level to "1.5", which corresponds to a new representative volume of "15".

In this specific example, the change in volume for playback per volume level when using the second volume scale 40 is half of the change in volume per volume level when using the first volume scale 30 for the volume levels in the lower half of the volume scale. This provides the user with greater control of the volume for playback by the electronic device 1.

In another example, the controller 7 is configured to automatically switch between using different volume scales depending on the time of day. This is advantageous because a user may always desire more control of the volume for playback at certain times of the day and automatically switching between using different volume scales avoids the need for the user to repeatedly do this manually.

A user may want more control of the volume for playback at night when the volume will usually be set quite low. This is because, as discussed above, electronic devices use a logarithmic scale to map selectable volume levels to volumes for playback due to the manner in which humans perceive sound. As a consequence, the change in loudness when a user switches between low volume levels is large compared to when switching between high volume levels.

Therefore, the controller 7 may be configured to switch between using the first volume scale 30 during the day (e.g. 7am-11pm) and using the second volume scale 40 during the night (e.g. 11pm-7am). The time period in a day that a controller 7 sets a particular volume scale for use by the electronic device 1 may be defined by a user or it may be pre-set by the manufacturer of the electronic device 1.

In use, when the electronic device 1 receives user input to change the volume level, the controller 7 first checks which volume scale is currently in use. The controller 7 then provides the appropriate adjustment in the volume level and thus the volume for playback according to the volume scale that is in use.

An advantage of this arrangement is that by providing more selectable volume levels, a user is allowed a greater degree of control of the volume for playback by the electronic device. This is particularly advantageous at low volumes because use of a logarithmic volume scale in mapping a selectable volume levels to volumes for playback as is used in many prior art devices can result in a lack of control over the volume for playback at low volume levels. That is, a small change in the volume level can cause a relatively large change in the loudness of the sound output by the electronic device. This problem is mitigated with the above arrangement by providing an alternate second volume scale that adds additional volume levels and corresponding volumes for playback.

It will be understood that the processor or processing system or circuitry referred to herein may in practice be provided by a single chip or integrated circuit or plural chips or integrated circuits, optionally provided as a chipset, an application-specific integrated circuit (ASIC), field-programmable gate array (FPGA), digital signal processor (DSP), graphics processing units (GPUs), etc. The chip or chips may comprise circuitry (as well as possibly firmware) for embodying at least one or more of a data processor or processors, a digital signal processor or processors, baseband circuitry and radio frequency circuitry, which are configurable so as to operate in accordance with the exemplary embodiments. In this regard, the exemplary embodiments may be implemented at least in part by computer software stored in (non-transitory) memory and executable by the processor, or by hardware, or by a combination of tangibly stored software and hardware (and tangibly stored firmware).

Reference is made herein to data storage for storing data. This may be provided by a single device or by plural devices. Suitable devices include for example a hard disk and non-volatile semiconductor memory.

Although at least some aspects of the embodiments described herein with reference to the drawings comprise computer processes performed in processing systems or processors, the invention also extends to computer programs, particularly computer programs on or in a carrier, adapted for putting the invention into practice. The program may be in the form of non-transitory source code, object code, a code intermediate source and object code such as in partially compiled form, or in any other non-transitory form suitable for use in the implementation of processes according to the invention. The carrier may be any entity or device capable of carrying the program. For example, the carrier may comprise a storage medium, such as a solid-state drive (SSD) or other semiconductor-based RAM; a ROM, for example a CD ROM or a semiconductor ROM; a magnetic recording medium, for example a floppy disk or hard disk; optical memory devices in general; etc.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. An electronic device having an audio playback function, the electronic device comprising:
a controller configured to:
provide a user with control of the volume for playback by the electronic device using a first volume scale, the first volume scale containing a first sequence of volume levels that each correspond to a different volume for playback by the electronic device, the first volume scale extending between a first volume and a second volume; and
switch between the first volume scale and a second volume scale, the second volume scale containing a second sequence of volume levels that each correspond to a different volume for playback by the electronic device, the second volume scale extending between the first volume and the second volume,
wherein the second volume scale has a smaller interval of volume change between at least two of its volume levels compared to the first volume scale, such that the second volume scale has a greater number of selectable volume levels than the first volume scale.

2. An electronic device according to claim 1, wherein the controller is configured to switch between the first volume scale and the second volume scale in response to user input.

3. An electronic device according to claim 2, comprising a receiver for receiving control signals from a remote control device, wherein the controller is configured to switch between the first volume scale and the second volume scale in response to user input from a remote control device.

4. An electronic device according to any of claims 1 to 3, wherein the controller is configured to switch between the first volume scale and the second volume scale based on the time of day.

5. An electronic device according to claim 4, wherein the controller is configured to switch between the first volume scale and the second volume scale based on a time of day configured by a user.

6. An electronic device according to any of claims 1 to 5, wherein the second volume scale includes smaller intervals between the volume levels and volumes for playback in the lower half of the volume scale than the upper half of the volume scale.

7. An electronic device according to any of claims 1 to 6, comprising data storage and wherein the first volume scale and the second volume scale are stored as information on the data storage.

8. A method for operating an electronic device having an audio playback function, the method comprising:
switching between a first volume scale and a second volume scale, the first volume scale containing a first sequence of volume levels that each correspond to a different volume for playback by the electronic device, the first volume scale extending between a first volume and a second volume, the second volume scale containing a second sequence of volume levels that each correspond to a different volume for playback by the electronic device, the second volume scale extending between the first volume and the second volume, wherein the second volume scale has a smaller interval of volume change between at least two of its volume levels compared to the first volume scale, such that the second volume scale has a greater number of selectable volume levels than the first volume scale.

9. A method for operating an electronic device according to claim 8, comprising switching between the first volume scale and the second volume scale in response to user input.

10. A method for operating an electronic device according to claim 8 or claim 9, comprising switching between the first volume scale and the second volume scale in response to user input from a remote control device.

11. A method for operating an electronic device according to any of claims 8 to 10, comprising switching between the first volume scale and the second volume scale based on the time of day.

12. A method for operating an electronic device according to claim 11, comprising receiving user input to configure a time of day for switching between the first volume scale and the second volume scale.

13. A method for operating an electronic device according to any of claims 8 to 12, wherein the second volume scale includes smaller intervals between the volume levels and volumes for playback in the lower half of the volume scale than in the upper half of the volume scale.

14. A method for operating an electronic device according to any of claims 8 to 13, comprising storing the first volume scale and the second volume scale on data storage.

15. A computer program comprising instructions such that when the computer program is executed on an electronic device having an audio playback function, the electronic device is arranged to:
provide a user with control of the volume for playback by the electronic device using a first volume scale, the first volume scale containing a first sequence of volume levels that each correspond to a different volume for playback by the electronic device, the first volume scale extending between a first volume and a second volume; and
switch between the first volume scale and a second volume scale, the second volume scale containing a second sequence of volume levels that each correspond to a different volume for playback by the electronic device, the second volume scale extending between the first volume and the second volume,
wherein the second volume scale has a smaller interval of volume change between at least two of its volume levels compared to the first volume scale, such that the second volume scale has a greater number of selectable volume levels than the first volume scale.
